(19) **Europäisches Patentamt**

**European Patent Office**

**Office européen des brevets**

(11) **EP 1 032 121 A1**

(12) **DEMANDE DE BREVET EUROPEEN**

(43) Date de publication:
**30.08.2000 Bulletin 2000/35**

(51) Int. Cl.⁷: **H03F 1/32**

(21) Numéro de dépôt: **00200527.0**

(22) Date de dépôt: **17.02.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **26.02.1999 FR 9902455**

(71) Demandeur:
**Koninklijke Philips Electronics N.V.
5621 BA  Eindhoven (NL)**

(72) Inventeur: **Chabas, Jean Alain
75008 Paris (FR)**

(74) Mandataire: **Chaffraix, Jean
Société Civile S.P.I.D.
156, Boulevard Haussmann
75008 Paris (FR)**

(54) **Appareil électronique comportant un amplificateur de puissance**

(57)  Cet appareil électronique comporte un amplificateur de puissance formé d'un étage final (21) présentant une caractéristique d'amplification non linéaire et d'un ensemble de correction (60, 46) pour compenser les non-linéarités de ladite caractéristique. Cet ensemble est constitué par un pré-amplificateur (46) de faible puissance de même type que ledit étage de puissance, présentant donc la même non-linéarité que l'étage 21.

Un dispositif de combinaison (60) en combinant les signaux appliqués à la borne d'entrée (25) avec les signaux de sortie dudit pré-amplificateur (25) contrecarre, en une large mesure, les non-linéarités desdites caractéristiques.

Applications : amplificateurs hautes fréquences

FIG. 2

EP 1 032 121 A1

**Description**

La présente invention concerne un appareil électronique comportant un amplificateur de puissance formé :

- d'un étage final présentant une caractéristique d'amplification non linéaire,
- d'un ensemble de correction pour compenser les non-linéarités de ladite caractéristique.

L'invention concerne aussi un amplificateur convenant à un tel appareil.

L'invention trouve des applications dans les appareils de radiotéléphonie mobiles pour lesquels les exigences de l'émetteur sont sévères en ce qui concerne la pureté du spectre des signaux émis. Ceci impose, entre autres, que l'amplificateur final travaillant en haute fréquence présente une très bonne linéarité d'amplification.

Le document de brevet japonais publié sous le numéro 08125554 décrit un tel amplificateur. Pour obtenir pour une bonne linéarité, on a prévu plusieurs moyens formant une structure plutôt complexe.

La présente invention propose un appareil du genre mentionné dans le préambule qui présente une structure plus simple.

Pour cela, un tel appareil est remarquable en ce que l'ensemble de correction comporte :

- un préamplificateur de faible puissance de même type que ledit étage de puissance,
- un dispositif de combinaison pour combiner les signaux d'entrée avec les signaux de sortie dudit préamplificateur pour contrecarrer les non linéarités desdites caractéristiques.

L' idée de l'invention est que lorsque les amplificateurs sont intégrés sur une même puce les caractéristiques sont semblables quelle que soit la puissance des amplificateurs, cette puissance dépendant en fait de la surface qu'occupent les transistors finals.

La description suivante, faite en regard des dessins ci-annexés, le tout donné à titre d'exemple non limitatif, fera bien comprendre comment l'invention peut être réalisée.

La figure 1 montre un appareil conforme à l'invention.

La figure 2 montre le schéma de réalisation de l'amplificateur de l'appareil de la figure 1.

La figure 3 montre une courbe de transfert d'un amplificateur présentant une non linéarité.

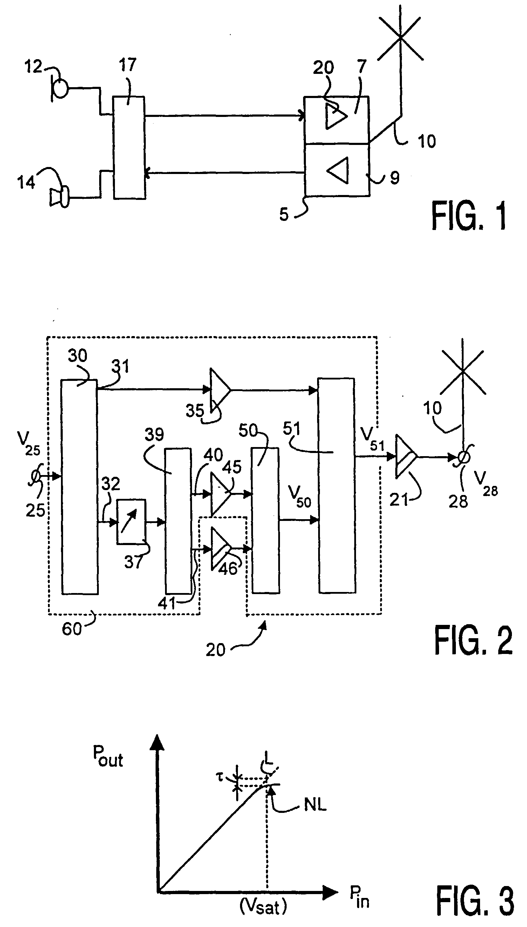

A la figure 1, on a représenté un appareil électronique conforme à l'invention. Cet appareil est un émetteur-récepteur tel une radio mobile dans un réseau cellulaire. Il se compose d'un ensemble d'émission-réception 5 comportant une partie émission 7 et une partie réception 9 pour émettre des signaux et pour en recevoir en utilisant une antenne 10. Les signaux à émettre proviennent notamment d'un microphone 12 et ceux qui sont reçus sont destinés notamment à un haut parleur 14. Un organe de traitement 17 assure l'interface entre les signaux à basse fréquence concernant le microphone 12 et le haut parleur 14 et l'ensemble 5.

L'ensemble d'émission-réception comporte un amplificateur haute fréquence 20 fournissant des signaux de puissance relativement élevée.

Cet amplificateur 20 est montré en détail à la figure 2. Il est composé essentiellement par un étage haute fréquence 21. Cet amplificateur 20 comporte une borne d'entrée 25 et une borne de sortie 28 qui est reliée à l'antenne 10. La borne d'entrée 25 est reliée à un diviseur de puissance 30 qui fournit deux signaux de même phase sur ses sorties 31 et 32. La sortie 31 est reliée à un premier amplificateur 35 et la sortie 32 aux entrées d'un ajusteur de niveau et de phase 37 dont la sortie est reliée à l'entrée d'un déphaseur 39. Cet ajusteur 37 permet de régler au mieux les dispersions électriques des différents éléments constituant l'amplificateur de l'invention. Cet ajusteur fournit à ses deux sorties 40 et 41 deux signaux dont un est en phase avec celui du signal d'entrée et l'autre en opposition de phase. Ces deux derniers signaux sont appliqués aux entrées de deux pré-amplificateurs 45 et 46. Les signaux de sortie des amplificateurs 35, 45 et 46 sont soustraits/additionnés par respectivement le circuits de soustraction 50 et par le circuit d'addition 51. Le signal de sortie du circuit 50 représente la distorsion qui a été ainsi extraite. Le signal de sortie du circuit 51 est un signal de prédistorsion à appliquer à l'étage 21.

L'amplificateur 21 présente une fonction de transfert non linéaire telle que présentée à la figure 3. Cette non linéarité survient d'une façon notable dès que le niveau d'entrée dépasse une certaine valeur $V_{sat}$ qui définit un certain taux de distorsion $\tau$ par exemple, l'écart en la caractéristique linéaire L et la partie non linéaire :

$$\tau = \frac{L\text{-}NL}{L}$$

Selon l'invention, l'amplificateur 46 doit aussi présenter cette non linéarité, tandis que les autres amplificateurs 35 et 45 sont considérés comme étant parfaits. Ils se combinent avec les autres éléments pour former un dispositif de combinaison 60.

Le fonctionnement d'un tel amplificateur repose sur les considérations suivantes.

La figure 3 montre une caractéristique d'amplification non linéaire qui représente la puissance de sortie 〈〈$P_{out}$〉〉 en fonction de la puissance d'entrée 〈〈$P_{in.}$〉〉. La non-linéarité NL survient pour les signaux de fortes amplitudes.

Si on considère le gain en tension des amplificateurs 35 et 45 on peut écrire :

$$V_{out} = A \, V_{in}$$

Le gain en tension des amplificateurs 46 et 21 s'écrit respectivement en ne gardant que les premiers termes d'un développement limité pour tenir compte des non linéarités :

$$V_{out} = A.V_{in} - \alpha \, V_{in}^2$$

$$V_{out} = k(A.V_{in} - \alpha \, V_{in}^2)$$

où A est le gain de l'amplificateur 46 et kA le gain de l'amplificateur 21,
et $\alpha$ représente la saturation de ces amplificateurs qui amène les non-linéarités.

Si on appelle $V_{25}$ le signal à l'entrée de l'amplificateur 20, le circuit de soustraction 50 fournit donc un signal $V_{50}$ :

$$V_{50} = A \, V_{25} - (A.V_{25} - \alpha \, V_{25}^2) = + \alpha \, V_{25}^2$$

A la sortie du circuit d'addition 51, on a une tension $V_{51}$ :

$$V_{51} = A.V_{25} + \alpha \, V_{25}^2$$

A la sortie 28 de l'amplificateur 21, la tension $V_{28}$ s'écrit :

$$V_{28} = k( A.V_{51} - \alpha \, V_{51}^2)$$

En détaillant on obtient :

$$V_{28}/k = A( A.V_{25} + \alpha \, V_{25}^2) - \alpha( A.V_{25} - \alpha \, V_{25}^2)^2$$

$$V_{28}/k = A^2 .V_{25} + \alpha .A (1 - A).V_{25}^2 - 2.A.\alpha^2.V_{25}^3 - \alpha^3 .V_{25}^4$$

Ainsi la contribution des non linéarités a bien diminué si l'on donne à A une valeur proche de 1 et en considérant que les termes en $V_{25}^3$ et en $V_{25}^4$ n'amènent qu'une contribution négligeable pour des non linéarités raisonnables.

**Revendications**

1. Appareil électronique comportant un amplificateur de puissance formé :

   - d'un étage final présentant une caractéristique d'amplification non linéaire,
   - d'un ensemble de correction pour compenser les non-linéarités de ladite caractéristique,

   caractérisé en ce que l'amplificateur de puissance comporte :

   - un préamplificateur de faible puissance de même type que ledit étage de puissance,
   - un dispositif de combinaison pour combiner les signaux d'entrée avec les signaux de sortie dudit préamplificateur pour contrecarrer les non linéarités desdites caractéristiques.

2. Appareil selon la revendication 1 caractérisé en ce que le dispositif de combinaison est formé :

   - d'un dispositif d'extraction de distorsion pour fournir un signal de distorsion représentant les non linéarités,

- d'un dispositif de pré-correction pour fournir à l'étage final un signal combinant le signal à amplifier avec ledit signal de distorsion.

3. Amplificateur convenant à un tel appareil selon l'une des revendications 1 ou 2, formé :

- d'un étage final présentant une caractéristique d'amplification non linéaire,
- d'un ensemble de correction pour compenser les non-linéarités de ladite caractéristique,

caractérisé en ce qu'il comporte :

- un préamplificateur de faible puissance de même type que ledit étage de puissance,
- un dispositif de combinaison pour combiner les signaux d'entrée avec les signaux de sortie dudit préamplificateur pour contrecarrer les non linéarités desdites caractéristiques.

4. Amplificateur selon la revendication 3, caractérisé en ce que le préamplificateur a un gain en tension proche de l'unité.

FIG. 1

FIG. 2

FIG. 3

**Office européen des brevets**    **RAPPORT DE RECHERCHE EUROPEENNE**

Numéro de la demande

EP 00 20 0527

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | EP 0 132 760 A (FUJITSU LTD) 13 février 1985 (1985-02-13) * page 4, ligne 20 - page 7, ligne 30; figures 3,4 * * page 10; revendication 10 * --- | 1-3 | H03F1/32 |
| X | RODRIGO CORDEIRO TUPYNAMBA ET AL: "MESFET NONLINEARITIES APPLIED TO PREDISTORTION LINEARIZER DESIGN" INTERNATIONAL MICROWAVE SYMPOSIUM DIGEST (MTT-S), ALBUQUERQUE, JUNE 1 - 5, 1992, vol. 2, 1 juin 1992 (1992-06-01), pages 955-958, XP000343462 REID D W * page 955 - page 957; figure 2 * ----- | 1-3 | |

**DOMAINES TECHNIQUES RECHERCHES (Int.Cl.7)**

H03F

Le présent rapport a été établi pour toutes les revendications

| Lieu de la recherche | Date d'achèvement de la recherche | Examinateur |
|---|---|---|
| LA HAYE | 8 juin 2000 | Tyberghien, G |

## ANNEXE AU RAPPORT DE RECHERCHE EUROPEENNE
## RELATIF A LA DEMANDE DE BREVET EUROPEEN NO.

EP 00 20 0527

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-06-2000

| Document brevet cité au rapport de recherche | Date de publication | Membre(s) de la famille de brevet(s) | | Date de publication |
|---|---|---|---|---|
| EP 0132760 A | 13-02-1985 | JP | 1848407 C | 07-06-1994 |
| | | JP | 5052084 B | 04-08-1993 |
| | | JP | 60025310 A | 08-02-1985 |
| | | DE | 3485947 A | 05-11-1992 |
| | | DE | 3485947 T | 18-02-1993 |
| | | US | 4550290 A | 29-10-1985 |

EPO FORM P0460

Pour tout renseignement concernant cette annexe : voir Journal Officiel de l'Office européen des brevets, No.12/82